# EUROPEAN PATENT APPLICATION

(11) **EP 3 098 870 A1**
(43) Date of publication of application: **30.11.2016**
(21) Application number: 15382285.3
(22) Date of filing: 29.05.2015
(51) Int. Cl.: H01L 51/42, H01L 51/44

(54) **NANOSTRUCTURED PEROVSKITE**

(71) Applicant: CONSEJO SUPERIOR DE INVESTIGACIONES CIENTIFICAS, 28006 Madrid (ES)
(72) Inventor: CALVO ROGGIANI, Mauricio Ernesto, 41092 ISLA DE LA CARTUJA, Sevilla (ES); MÍGUEZ GARCÍA, Hernán Ruy, 41092 ISLA DE LA CARTUJA, Sevilla (ES); GALISTEO LÓPEZ, Juan Francisco, 41092 ISLA DE LA CARTUJA, Sevilla (ES); ANAYA MARTÍN, Miguel, 41092 ISLA DE LA CARTUJA, Sevilla (ES)
(74) Representative: Pons

(57) **Abstract**

The invention provides an optoelectronic device comprising a porous material and a material with perovskite crystal structure in contact with the porous material. The porous material is further characterised in that the pores present a well defined average size, in the range of 1-100nm, and characterised in that it is an ordered network which shows a periodicity in one, two or three spatial directions. The perovskite material is infiltrated within the porous material, resulting in a mesostructured and ordered perovskite material.

This spatially confined perovskite shows a luminescent emission whose range of wavelengths can be modified changing the pore size of the mesostructure. This invention solves the problem of tuning the emission of perovskite materials without varying their composition. The invention can be used as both light emitting and photovoltaic devices.

## Description

### FIELD OF THE INVENTION

The present invention relates to the field of optoelectronics, in particular both light emitting devices and photovoltaic devices.

### BACKGROUND ART

In recent years the organic and/or inorganic halides perovskites materials have attracted the attention of technicians in the field of photovoltaic due to the high conversion efficiency of light into electrical power that these materials present [J. Phys.Chem. Lett. 2013, 4, 2597.]. On the other hand, these same perovskite materials have also attracted interest as light-emitting materials, since they have a well-defined emission peak with maximum value falling within a narrow range of wavelengths in the far-red and near infrared. Their technological value has been demonstrated through the realization of an electrically excited light emitting device [WO2013171520A1].

The different manufacturing processes of the perovskite that have been used so far include its manufacture in film form (Nature 501, 395-398, 2013), in bulk [Science 347, 522-524, 2015] or filling different kind of porous scaffolds. In this last case, the porous scaffolds have been built using different techniques like spin coating [Science 338, 643-647, 2012] or screen printing [Science 345, 295 (2014)]. TiO₂ and Al₂O₃ nanoparticulated layers were frequently used as porous scaffolds and layers of SiO₂ or ZrO₂ particles were employed too [RSC Adv., 2013, 3, 18762-18766].

In any of the aforementioned configurations of the perovskite, there is no control over its properties of absorption and emission. Therefore, modifying the spectral features of the emission and/or absorption of an existing perovskite based optoelectronic device today necessarily involves the replacement of the perovskite compound. [J. Phys. Chem. Lett. 2014, 5, 1421]. This limitation of the present technology implies that for each different light emitting diode (LED), that is, for each colour, it is necessary to synthetize a different perovskite compound and, consequently, to use different components in the system. Moreover, using this approach, a fine emission colour tuning has not been demonstrated, but only well-defined emission around 515 nm (green), 630 nm (red) and 750 nm (deep red) for perovskite films of compositions CH3NH3PbBr3, CH3NH3PbBr2l and CH3NH3Pbl3, respectively. [Nat. Nanotechnol. 2014, 9, 687]

Due to the referred limitations there is an increasing interest in having alternative methods to change the colour of the perovskite emission.

### BRIEF DESCRIPTION

A first aspect of the present invention relates to an optoelectronic device, comprising:
(i) a porous material; and
(ii) a material with perovskite crystal structure in contact with the porous material, wherein the said perovskite material is in form of paticles of sizes equal or below 100nm.

A second aspect of the present invention relates to a process to obtain the optoelectronic device as defined above, comprising the following steps:
(i) disperse organic macromolecules and metal oxide precursor compounds in a liquid medium in molar relations in the range of 0.005-0.1 moles of organic molecule and in the range of 10-50 moles of solvent by mol of metal;
(ii) heat the dispersion to phase mixing;
(iii) immerse in the dispersion a planar substrate;
(iv) allow the liquid medium to evaporate from the planar substrate and condense the metal oxide around organic macromolecules self-assembled;
(v) heat the deposited film on the planar substrate to stabilize the metal oxide structure and to remove the polymer, creating a porous structure;
(vi) infiltrate the porous structure with precursors of perovskite structure materials; and
(vii) heat to activate the reaction between the precursors and lead to the formation of perovskite structure material in the metal oxide porous structure.

A third aspect of the present invention relates to a process to obtain the optoelectronic device as defined above, comprising the following steps:
(i) create a film of block copolymer comprising at least two different polymers;
(ii) heat to induce the segregation in two phases;
(iii) expose the film to ultraviolet radiation to induce the degradation of at least one of the polymer phases forming the film;
(iv) immerse the film in acetic acid to dissolve at least one of the polymer phases, forming the porous structure;
(v) infiltrate the porous structure with precursors of perovskite structure materials; and
(vi) heat to activate the reaction between the precursors and lead to the formation of perovskite structure material in the polymer porous structure.

### BRIEF DESCRIPTION OF THE DRAWINGS

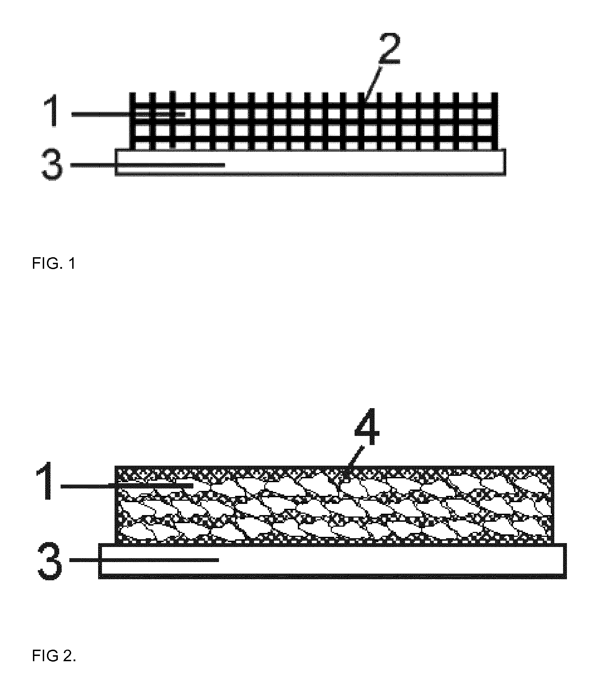

FIG. 1 shows an esquematic diagram of the optoelectronic device comprising a mesostructured porous metal oxide material. (1) perovskite, (2) metal oxide, (3) substrate.
FIG. 2 shows an esquematic diagram of the optoelectronic device comprising a porous polimeric material. (1) perovskite, (4) polymer, (3) substrate.

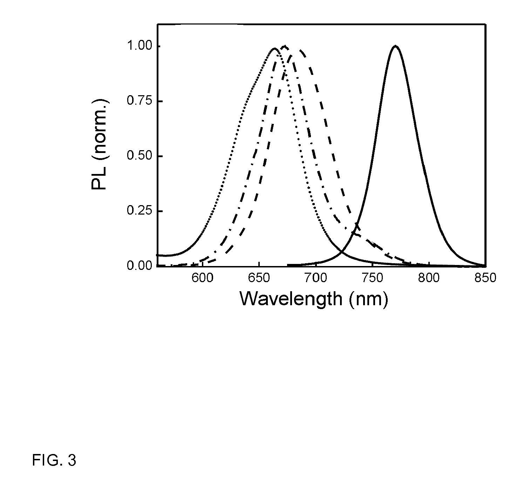

FIG. 3 shows emission spectra of a mesostructured perovskite homogeneous in grain size and ordered. On the graph the wavelenth in nm, of the light emitted by the perovskite, is plotted on the x-axis and the intensity of the photoluminiscence, normalized to its maximum, is plotted on the y-axis. The black solid line corresponds to a non-structured persovskite. The dash line corresponds to a perovskite of grain sizes of 13-35nm (big size grains), the dash-dot line corresponds to a perovskite of grain sizes of 9nm (medium size grains) and the dot line corresponds to a perovskite of grain sizes of 5nm (small size grains).

### DETAILED DSECRIPTION

According to the present invention, there is provided a hybrid nanostructured material based on a porous material, which acts as a scaffold and an organic and/or inorganic halide compound that crystallizes taking the perovskite structure. The porous material is an ordered network which shows a periodicity in one, two or three spatial directions and this periodicity has lattice constants with values between 1nm and 200nm. Furthermore the porous material has a pore size distribution characterized by a standard deviation less than 50%, around an average value between 1 nm and 100 nm.

According to the first aspect of the invention, the pore size distribution of the porous material that acts as scaffold determines the spectral position and width of the maximum of luminescence emission of the perovskite material that is in contact with it. The perovskite material crystalizes within the pores of the porous scaffold. The homogeneity in the pores sizes and the ordered distribution of them forced the perovskite crystal to grow both taking the form of crystalline particles of controlled size and in well defined spatial locations. This characteristic provides a fine control of the absorption and emission properties of the perovskite material. Hence, this aspect of invention is advantageous in that it provides a mean of tuning the absorption and emission spectrum of the same perovskite material. That is, this aspect of the invention makes no longer necessary to synthetize a perovskite with a different chemical composition in order to change the spectral position of the maximum of emission or the spectral position of the absorption band gap.

In another embodiment the invention relates to the optoelectronic device as defined above, wherein the porous material comprises an ordered network which shows a periodicity in one, two or three spatial directions and this periodicity has lattice constants with values between 1nm and 200nm.

In another embodiment the invention relates to the optoelectronic device as defined above, wherein the porous material has a pore size distribution characterized by a standard deviation less than 50%, around an average value between 1 nm and 100 nm.

In another embodiment the invention relates to the optoelectronic device as defined above, wherein the pore size distribution of the porous material determines the spectral position and width of the maximum of luminescence emission.

In another embodimen the invention relates to the optoelectronic device as defined above, wherein the porous material comprises a metal oxide, preferably wherein the porous material comprises a metal oxide (2), and more preferably wherein the metal oxide (2) is selected from among SiO₂, TiO₂, SnO₂, ZnO, ZrO₂, Nb₂O₅, CeO₂, Fe₂O₃, Fe₃O₄, V₂O₅, Cr₂O₃, HfO₂, MnO₂, Mn₂O₃, Co₃O₄, NiO, Al₂O₃, In₂O₃, SnO₂.

In another embodimen the invention relates to the optoelectronic device as defined above, wherein the porous material comprises at least a polymeric compound (4), preferably wherein the porous material comprises at least a polymeric compound, and more preferably wherein the polymeric compound (4) is selected from among polystyrene, polyvinyilpirrolidone, polyalquilacrylate, polyarylacrylate, polydimethylsiloxane, polycarbonate and polyurethane.

These well-defined pore films are prepared by depositing precursors of different types on a flat substrate. Each precursor results in different pore structure, geometry, connectivity, average size and distribution of different sizes. The different resulting porous structures can be used to attain mesostructured perovskite with the properties described above.

The ordered hybrid mesostructured perovskite material is useful as a light emitting device and a photovoltaic cell, since the metal oxides and the polymer used as porous scaffolds are compatible and similar in composition to those used in these technologies. Furthermore, the methods of fabrication of the hybrid mesostructured perovskite material are compatible with the manufacturing techniques employed to produce these devices.

In another embodiment the invention relates to the optoelectronic device as defined above, wherein the optoelectronic device is selected from a photovoltaic device or a light emitting device.

The invention is also directed to a method for producing the porous material and the ordered mesostructured perovskite material within the pores. The porous material of the optoelectronic device of the invention is produced as follows.

According to the second and third aspects of the invention, the compounds used to prepare porous ordered mesostructured scaffolds are a mixture of organic macromolecules and metal oxide precursors in solution, which gives rise to optical quality thin films, with well-defined pore sizes and ordered pores by the technique known as supramolecular molding or templating [J. Am. Chem. Soc. 2003, 125, 9770]. Well defined pore size is considered here to be equivalent to a pore size distribution with a standard deviation at least of 50%, expressed in units of "pore radius frequency" versus "pore radius", when characterized by any of the techniques typically used for this purpose. Optical quality is considered here to be equivalent to not to show diffuse light scattering phenomena as a result of the presence of disorder or imperfections, and thus allowing a better control the emitted light angular scattering.

The supramolecular molding technique consists in dispersing an organic macromolecule in a liquid medium so that a phase separation occurs. The resulting polymeric phase after the macromolecules assembly can be continuous, bi-continuous or aggregated in form of particles or lamellae. This self-organization allows that metal oxides materials from precursor species that are dissolved in the precursor solution, condense around the polymer phase. Once the film is stabilized, the organic phase, which is trapped in inorganic (the metal oxide), is removed by heating or by chemical treatment. The final material presents a periodical ordered pore network with connectivity from the top to the bottom of the layer.

In another embodiment the invention relates to the process to obtain the optoelectronic device as defined in the second aspect of the invention, wherein the macromolecules used as templates in this preparation are block copolymers whose structural unit is formed by joining two or more polymer chains of almost two different types. The metal oxides which can be obtained from the precursors are: SiO₂, TiO₂, SnO₂, ZnO, ZrO₂, Nb₂O₅, CeO₂, Fe₂O₃, Fe₃O₄, V₂O₅, Cr₂O₃, HfO₂, MnO₂, Mn₂O₃, Co₃O₄, NiO, Al₂O₃, In₂O₃, SnO₂.

Alternatively, the porous material of the optoelectronic device of the invention is obtained through treating of a diblock copolymer. In this preferred invention, the block copolymer is deposited in a shape of a film. After an annealing process, each polymer chain segregates in two ordered phases. This segregation leads to a well-defined geometry of the phases depending on the composition of the block copolymer and the chemical nature of each moiety. The selective removal of one of these constituents directs to a perforated layer structure. This material presents an interconnected network of pores and a bi-modal distribution of the pore size.

According to the second and third aspects of the invention, both materials support the synthesis of the nanostructured perovskite material within the pores. Both scaffolds stand the solvents used to dissolve perovskite precursors (dimethylsulfoxide, dimethylformamide, gammabutyrolactone, N-methyl-2-pyrrolidone) and the solvents (chlorobenzene, toluene) used to anneal and crystallize the perovskite structure.

In both processes for obtaining the optoelectronic device previously described, the perovskite material within the pores of the porous materials is developed as follows. An organic amine aqueous (or ethanolic) solution is mixed with an hydrogen halide aqueous solution. The mixing medium is ethanol and both compounds react during 120 minutes. After that, solvent is removed by evaporation at reduced pressure. Crystals obtained are washed and then dried in a vacuum stove. Next, the organic ammonium halide is dissolved in an appropriate solvent. After that, a lead halide compound is dissolved in the previous solution. This solution is suitable to infiltrate the mesoporous scaffolds by spin-coating or dip-coating or any other liquid processing method. The final step is the thermal treatment of the hybrid mesoporous-organic/inorganic halide perovskites that leads to a mesostructured optoelectronic material.

The perovskite crystal structure comprises at least one anion selected from halide anions and/or chalcogenide anions, and two cations. In a preferred embodiment of the invention, the first cation of the said two cations is an organic cation. In an embodiment of the invention, the said organic cation has the formula (R₅NH₃)⁺, wherein R₅ is hydrogen, or unsubstituted or substituted C₁-C₂₀ alkyl. In an embodiment of the invention, the said organic cation is [HC(NH₂)₂]⁺. In another preferred embodiment of the invention, the first cation of the said two cations is an element of the alkali metal group. The second cation of the said two cations is a metal cation that can be selected from Sn²⁺, Pb²⁺, Zn²⁺, or Cu²⁺.

The invention is advantageous in that it provides a mesostructured perovskite that has an intense and well defined luminescence peak, presenting a spectral width at half maximum divided by the position of the maximum of around 6%, and whose spectral position depends on the size of the pores that host the perovskite material, as shown in Figure 3. In an embodiment of the present invention, the spectral range in which the luminescence can be selected goes from wavelength of 550 nm up to 780 nm, when using CH₃NH₃Pbl₃ perovskite compound. In another embodiment of the present invention, the spectral range in which the luminescence can be selected goes from wavelength of 400 nm up to 550 nm, when using CH₃NH₃PbBr₃ perovskite compound.

A further advantage arises from a very significant reduction of the lifetime of the excited states of the perovskite synthesized within the ordered mesoporous scaffold with respect to the same perovskites not mesostructured. This implies that faster transfer of charges to the scaffold can be achieved, which may result in higher photovoltaic efficiencies when integrated in a solar cell.

The invention is advantageous in that it provides a material to be used as a light emitting device wherein the colour of emission can be tuned without altering the composition of the emissive material. Another advantage of the invention when using it in photovoltaic applications is to control the spectral position of the absorption edge, which provides a control of the colour and/or transparency of the cell.

Throughout the description and claims the word "comprise" and variations of the word, are not intended to exclude other technical features, additives, components, or steps. Furthermore, the word "comprise" encompasses the case of "consisting of". Additional objects, advantages and features of the invention will become apparent to those skilled in the art upon examination of the description or may be learned by practice of the invention. The following examples and drawings are provided by way of illustration, and they are not intended to be limiting of the present invention. Furthermore, the present invention covers all possible combinations of particular and preferred embodiments described herein.

### EXAMPLES

The invention is illustrated further in the following non-limiting Examples.

### Example 1: ordered mesostructured porous metal oxide material - small size pores.

The liquid dispersion to obtain a TiO₂ matrix with a small pore size (5-6 nm) was prepared by adding the selected amphiphilic molecules to obtain the desired porous size to a solution containing TiCl₄:EtOH 1:40. To 20 ml of this solution we add C₁₆H₃₃(EO)₁₀ (brij56) or trimethylcetylammonium bromide (CTAB) In both cases we used 0.311 g of the surfactant and 1.61 ml of water. These solutions were stirred during 30 minutes. The next phase in the preparation of this material is at the deposition section (see below)

### Example 2: ordered mesostructured porous metal oxide material - intermedium size pores.

The precursor sol to obtain an intermediate pore size (8-12)nm was prepared by adding 0.573 g (EO)₁₀₆(PO)₇₀(EO)₁₀₆ (commercial name, F127), where EO stands for ethylene oxide and PO for propylene oxide monomers, to 20ml of a solution containing TiCl₄:EtOH 1:40. Finally 1.61 ml of water were added to the mix. These solutions were stirred during 30 minutes.

The next phase in the preparation of this material is at the deposition section (see below)

### Example 3: ordered mesostructured porous metal oxide material - big size pores.

A quantity of 12.6 grams of a TiCl₄:BuOH solution (molar ratio Ti/BuOH= 1:40) was used to dissolve 0.28 g of F127. After 10 minutes of vigorous mixing, 0.72g of H₂O were added and then 0.24 g of polypropylene glycol 4000 (Alfa Aesar GMBH&Co KG) were incorporated to the sol. Finally, 4 ml of tetrahidrofuran (THF) are mixed with the sol during 30 minutes. The next phase in the preparation of this material is at the deposition section (see below)

### Deposition

The following treatment is the same to the previous examples: Coatings with the dispersions were made immersing a clean substrate in each one and pulling at a controlled speed. The speed of pulling is related with the thickness of the mesoporous layer. The speed was varied between 0.5 and 2 mm/s, which allowed us to attain thicknesses comprised in the 50 nm-200 nm range. In some cases we needed to make 2 sequential depositions to obtain larger thickness. After each layer was deposited, samples were introduced into a 50% relative humidity chamber for 24 hours, then thermally stabilized at 60°C and 120°C during 24h and finally at 200°C during 2h. The organic template is removed by treating the samples at 350°C for 1h (ramp 1°C/min).

Next phase from here is the preparation of the perovskite precursors (see below).

### Example 4: mesostructured porous polymer material.

The polystyrene porous network is made by the selective chemical attack of a diblock copolymer preferentially poly(methylmethacrylate) poly(styrene) (abbrev. PMMA-PS) 81.5kDa, ratio PMMA/PS=0.15. This copolymer can be deposited by spin coating a 5%(w/w) solution in toluene. After a treatment of the block copolymer layer with monochromatic UV- radiation (8 joules, λ=254nm) and the further immersion in glacial acetic acid, a selective removal of PMMA is achieved. The final material consists in a porous film of PS Next phase from here is the preparation of the perovskite precursors.

### Preparation of perovskite precursors

We started with a methylamine aqueous solution (35% w/w) combined with an aqueous solution of hydriodic acid (40% w/w). Both compounds were dissolved in ethanol at 0°C and allowed to react during 120 minutes. After that, solvent was removed by evaporation at reduced pressure. The obtained crystals of methylammonium iodide were washed with di-ethylether and then dried in a vacuum stove overnight at 60°C. An amount of 0.672g of the amine halide was dissolved in 1.6 ml of anhydrous dimethylformamide. After that, 0.390g of PbCl₂ was added to the solution under vigorous stirring. A clear yellow solution is obtained.

### Infiltration of porous structures with perovskite precursor

The infiltration of porous structure with the perovskite precursors was made by spin coating. This technique allowed to infiltrate the structure from top to the bottom controlling the perovskite filling thickness. Final rotation speed was selected at 5000rpm to allow a complete infiltration of the pores but preventing an over-layer of perovskite.

## Claims

1. An optoelectronic device, comprising:
(i) a porous material; and
(ii) a material with perovskite crystal structure (1) in contact with the porous material, wherein the said perovskite material (1) is in form of particles of sizes equal or below 100nm.

2. The optoelectronic device according to claim 1 wherein the porous material comprises an ordered network which shows a periodicity in one, two or three spatial directions and this periodicity has lattice constants with values between 1nm and 200nm.

3. The optoelectronic device according to claim 1 wherein the porous material has a pore size distribution **characterized by** a standard deviation less than 50%, around an average value between 1 nm and 100 nm.

4. The optoelectronic device according to claim 3, wherein the pore size distribution of the porous material determines the spectral position and width of the maximum of luminescence emission.

5. The optoelectronic device according to any of claims 1 to 4, wherein the porous material comprises a metal oxide (2).

6. The optoelectronic device according to claim 5 wherein the metal oxide (2) is selected from among SiO₂, TiO₂, SnO₂, ZnO, ZrO₂, Nb₂O₅, CeO₂, Fe₂O₃, Fe₃O₄, V₂O₅, Cr₂O₃, HfO₂, MnO₂, Mn₂O₃, Co₃O₄, NiO, Al₂O₃, In₂O₃, SnO₂.

7. The optoelectronic device according to any of claims 1 to 4, wherein the porous material comprises at least a polymeric compound (5).

8. The optoelectronic device according to claim 7 wherein the polymeric compound (5) is selected from among polystyrene, polyvinyilpirrolidone, polyalquilacrylate, polyarylacrylate, polydimethylsiloxane, polycarbonate and polyurethane.

9. The optoelectronic device according to any of claims 1 to 8, wherein the optoelectronic device is selected from a photovoltaic device or a light emiting device.
